# EUROPEAN PATENT SPECIFICATION

(11) **EP 0 428 260 B1**
(45) Date of publication and mention of the grant of the patent: **05.01.2000**
(21) Application number: 90310803.3
(22) Date of filing: 03.10.1990
(51) Int. Cl.: C23F 11/14, B23K 35/363

(54) **Metal surface treatment agents**
Mittel zur Behandlung von Metalloberflächen
Agents de traitement de surfaces métalliques

(30) Priority: 03.10.1989 JP 25856489; 13.02.1990 JP 2963090
(43) Date of publication of application: 22.05.1991
(73) Proprietor: SANWA LABORATORY LTD., Itabashi-ku, Tokyo 174 (JP); MORIMURA BROS., Inc.,, Minato-ku, Tokyo 105 (JP)
(72) Inventor: Kawai, Hideyuki, Chichibu-gun, Saitama (JP)
(74) Representative: Davies, Jonathan Mark

(56) References cited:
- EP-A- 0 226 016
- EP-A- 0 291 743
- FR-A- 2 089 003
- GB-A- 2 104 107
- US-A- 4 235 838
- DATABASE WPI, no. 73-65416u, Derent Publications Ltd. London, GB; & JP-A-48 034 491 TOKYO SHIBAURA ELECTRIC CO., LTD) 22-10-1973

## Description

### BACKGROUND OF THE INVENTION

### 1. Field of the Invention

The present invention relates to a surface treating agent for metal work, more particularly, an agent for treating a surface of the metal work to protect the surface from an adverse action such as oxidation, and to confer a rust proofing property to the surface. Especially, the surface treating agent of the present invention can be advantageously used as a preflux in the production of printed circuit boards.

### 2. Description of the Related Art

Currently, many kinds of prefluxes are widely used in the production of printed circuit boards to protect circuits, consisting of copper or alloy thereof, of the boards from the formation of rust, and to retain a good solderability of the circuits. These prefluxes are broadly divided into two types of prefluxes, i.e., rosin-based prefluxes which are coated over a whole surface of the printed circuit boards, and alkylimidazole-based prefluxes which are applied onto a surface of the circuit boards to selectively cause a chemical reaction between the alkylimidazole and copper or alloy thereof (for example, Cu-Zn alloy) of the circuits, to thereby improve a solderability of the circuits. The rosin-based prefluxes include, for example, naturally occurring rosins, rosin esters and rosin-modified maleic acid resins, and are roll-coated, spray-coated or dip-coated over a whole surface of the circuit boards, after dissolution in an organic solvent. The thus-obtained coating is then dried to form a preflux coating. Due to the incorporation of the volatile organic solvent, these rosin resin-based prefluxes suffer from drawbacks such that the working environment and safety of the workers are notably adversely affected, and further, suffer from a drawback such that the volatile solvent used can be ignited during the coating of the prefluxes and the subsequent soldering.

On the other hand, the alkylimidazole-based prefluxes are water-based, and therefore, are more practical from the viewpoint of the working environment and the safety of the workers. Nevertheless, when exposed to a highly elevated temperature, the reaction product of the alkylimidazole and copper, i.e., copper complex of alkylimidazole, is modified as a result of a catalytic action of the oxygen in air and copper, and the modified reaction product blocks an action of the postfluxes (assembly fluxes) generally used after the fabrication of electronic parts on the circuit boards, and thus lowers the solderability of the circuits.

Recently, a surface mount technology (SMT) has been widely adopted for soldering electronic parts or chips onto the printed circuit boards, as this enables the parts or chips to be mounted at a high density. To be able to use the prefluxes in this surface mount technology to retain a solderability of the printed circuit boards, the prefluxes must satisfy a requirement of a good thermal resistance. This is because, in the SMT, the circuit boards are frequently exposed to a highly elevated temperature (for example, when electronic parts are provisionally mounted on the boards or when a reflow soldering of solder cream is carried out during a microsoldering process). Namely, since an excellent solderability is essential to the circuit boards after exposure thereof to a high temperature, the prefluxes used in the SMT must ensure an excellent solderability.

Therefore, there is a need to provide a novel preflux which is stable at a high temperature, and thus can retain an excellent solderability of the printed circuit boards during and after exposure of the boards to high temperature conditions.

There is also a need to provide a novel preflux which can be used in the absence of volatile solvents, i.e., which excludes the use of the volatile solvents in the preparation of the preflux solution or emulsion for use during the coating. Note, as previously described, the volatile solvents are causes of environmental pollution and other problems.

In addition to the preflux, there is also a need to provide a novel surface treating agent which can be used to improve the surface characteristics of the metal work or work having a metal surface.

### SUMMARY OF THE INVENTION

According to the present invention, there is provided a surface treating agent for metal work which contains, as an active component thereof, at least one benzimidazole compound selected from the list set out below represented by the following formula (I): 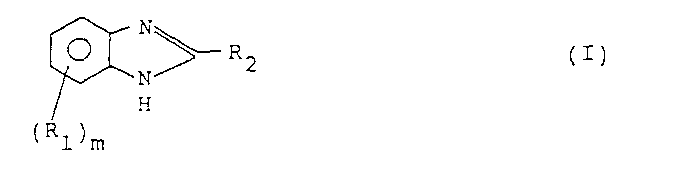 in which
R₁ independently represents a substituted or unsubstituted alkyl group of 1 to 6 carbon atoms,
m is an integer of 0 to 2, and
R₂ independently represents a substituted or unsubstituted alkyl group of 3 to 17 carbon atoms.

The surface treating agent according to the present invention can be used to treat a surface of any metal work, as long as the work has a metal layer or coating to be treated at at least a surface portion of the work, and further, an improvement of surface properties such as flux effect, solderability, oxidation prevention, rust prevention, adhesion promotion and the like, of the metal surface of the work is required. Especially, the surface treating agent of the present invention can be effectively used as a preflux in the production of printed circuit boards.

According to the present invention, as described hereinafter in detail, many remarkable effects can be obtained by this invention. For example, when the surface treating agent is used as a preflux for printed circuit boards, the preflux coating formed on a surface of, e.g., copper or an alloy thereof, for example, Cu or Cu-Zn, circuits exhibit an excellent thermal resistance, and therefore, can also exhibit a good wettability by solder after exposure of the boards to high temperature conditions. The preflux can provide remarkably excellent effects when utilized for a surface mounting of electronic components on the printed circuit boards.

### DESCRIPTION OF THE PREFERRED EMBODIMENTS

The surface treating agent of the present invention contains, as an active component thereof, at least one 2-alkyl-alkylbenzimidazole. Surprisingly, these benzimidazoles including derivatives thereof are superior to the prior art alkylimidazole-based prefluxes.

Typical examples of 2-alkyl-alkylbenzimidazoles useful in the practice of the present invention are selected from the group consisting of :
- AABI-7: 2-n-propyl-benzimidazole,
- AABI-8: 2-n-propyl-methylbenzimidazole,
- AABI-9: 2-n-propyl-dimethylbenzimidazole,
- AABI-10: 2-n-butyl-benzimidazole,
- AABI-11: 2-n-butyl-methylbenzimidazole,
- AABI-12: 2-n-butyl-dimethylbenzimidazole,
- AABI-13: 2-n-pentyl-benzimidazole,
- AABI-14: 2-n-pentyl-methylbenzimidazole,
- AABI-15: 2-n-pentyl-dimethylbenzimidazole,
- AABI-16: 2-n-hexyl-benzimidazole,
- AABI-17: 2-n-hexyl-methylbenzimidazole,
- AABI-18: 2-n-hexyl-dimethylbenzimidazole,
- AABI-19: 2-n-heptyl-benzimidazole,
- AABI-20: 2-n-heptyl-methylbenzimidazole,
- AABI-21: 2-n-heptyl-dimethylbenzimidazole,
- AABI-22: 2-n-octyl-benzimidazole,
- AABI-23: 2-n-octyl-methylbenzimidazole,
- AABI-24: 2-n-octyl-dimethylbenzimidazole,
- AABI-25: 2-n-nonyl-benzimidazole,
- AABI-26: 2-n-nonyl-methylbenzimidazole,
- AABI-27: 2-n-nonyl-dimethylbenzimidazole,
- AABI-28: 2-n-decyl-benzimidazole,
- AABI-29: 2-n-decyl-methylbenzimidazole,
- AABI-30: 2-n-decyl-dimethylbenzimidazole,
- AABI-31: 2-n-undecyl-benzimidazole,
- AABI-32: 2-n-undecyl-methylbenzimidazole,
- AABI-33: 2-n-undecyl-dimethylbenzimidazole,
- AABI-34: 2-n-dodecyl-benzimidazole,
- AABI-35: 2-n-dodecyl-methylbenzimidazole,
- AABI-36: 2-n-dodecyl-dimethylbenzimidazole,
- AABI-37: 2-n-tridecyl-benzimidazole,
- AABI-38: 2-n-tridecyl-methylbenzimidazole,
- AABI-39: 2-n-tridecyl-dimethylbenzimidazole,
- AABI-40: 2-n-tetradecyl-benzimidazole,
- AABI-41: 2-n-tetradecyl-methylbenzimidazole,
- AABI-42: 2-n-tetradecyl-dimethylbenzimidazole,
- AABI-43: 2-n-pentadecyl-benzimidazole,
- AABI-44: 2-n-pentadecyl-methylbenzimidazole,
- AABI-45: 2-n-pentadecyl-dimethylbenzimidazole,
- AABI-46: 2-n-hexadecyl-benzimidazole,
- AABI-47: 2-n-hexadecyl-methylbenzimidazole,
- AABI-48: 2-n-hexadecyl-dimethylbenzimidazole,
- AABI-49: 2-n-heptadecyl-benzimidazole,
- AABI-50: 2-n-heptadecyl-methylbenzimidazole,
- AABI-51: 2-n-heptadecyl-dimethylbenzimidazole,
- AABI-52: 2-isopropyl-benzimidazole,
- AABI-53: 2-isopropyl-methylbenzimidazole,
- AABI-54: 2-isopropyl-dimethylbenzimidazole,
- AABI-55: 2-isobutyl-benzimidazole,
- AABI-56: 2-isobutyl-methylbenzimidazole,
- AABI-57: 2-isobutyl-dimethylbenzimidazole,
- AABI-58: 2-isopentyl-benzimidazole,
- AABI-59: 2-isopentyl-methylbenzimidazole,
- AABI-60: 2-isopentyl-dimethylbenzimidazole,
- AABI-61: 2-isohexyl-benzimidazole,
- AABI-62: 2-isohexyl-methylbenzimidazole,
- AABI-63: 2-isohexyl-dimethylbenzimidazole,
- AABI-64: 2-neopentyl-benzimidazole,
- AABI-65: 2-neopentyl-methylbenzimidazole,
- AABI-66: 2-neopentyl-dimethylbenzimidazole,
- AABI-67: 2-sec.-butyl-benzimidazole,
- AABI-68: 2-sec.-butyl-methylbenzimidazole,
- AABI-69: 2-sec.-butyl-dimethylbenzimidazole,
- AABI-70: 2-tert.-butyl-benzimidazole,
- AABI-71: 2-tert.-butyl-methylbenzimidazole,
and
- AABI-72: 2-tert.-butyl-dimethylbenzimidazole.

The above-described benzimidazoles, which may be used separately or as a mixture of two or more imidazoles, are preferably used as a solution or emulsion containing 0.01 to 40%, more preferably, 0.5 to 5% of the benzimidazoles in a non-volatile solvent.

In the preparation of the solution or emulsion of the benzimidazoles, a wide variety of non-volatile solvents can be used, and suitable non-volatile solvents are preferably selected from the group consisting of organic acids, salts of organic acids, aqueous solutions containing inorganic acids and/or inorganic salts, water-soluble solvents, and a mixture thereof. Typical examples of suitable non-volatile solvents include:
organic acids:
   acetic acid, capric acid, glycolic acid, para-nitrobenzoic acid, para-toluene sulfonic acid, picric acid, oxalic acid, formic acid, succinic acid, phosphorous acid, maleic acid, acrylic acid, fumaric acid, tartaric acid, adipic acid, lactic acid, oleic acid and the like.
salts of organic acids:
   salts of above-listed organic acids.
inorganic acids:
   hydrochloric acid, sulfuric acid, phosphoric acid and the like.
inorganic salts:
   zinc acetate, lead acetate, zinc hydroxide, lead hydroxide, zinc sulfide, zinc phosphate, zinc oxide, zinc chloride, ferrous chloride, ferric chloride, ferrous oxide, ferric oxide, cuprous chloride, cupric chloride, cuprous oxide, cupric oxide, copper hydroxide, copper (II) phosphate, copper (I) carbonate, copper (II) acetate, copper (II) sulfate and the like.
water-soluble solvents:
   methanol, ethanol, isopropyl alcohol, butanol, acetone and the like.
Note, these solvents may be used separately or as a mixture of two or more thereof. When the solvents are used as a mixture thereof, a mixing ratio of each solvent can be widely varied depending upon factors such as the specific benzimidazole used and the desired results.

With regard to the use of the mixed solvents, preferably the water-soluble solvent(s) is used in combination with the organic acid(s) or the like. This is particularly effective if the use of the organic acid(s) or the like alone will not dissolve 2-alkyl-alkylbenzimidazole, 2-phenyl-alkylbenzimidazole or derivatives thereof therein. The water-soluble solvent(s) are preferably used in an amount of 50% or less of the mixed solvents.

In addition to the benzimidazoles, the surface treating agent of the present invention may contain additives which are conventional in the field of surface treating agents, and especially prefluxes, if desired. Suitable additives include, for example, antioxidants, colorants and the like.

The surface treating agent according to the present invention, when applied as a solution or emulsion thereof onto a surface of the metal articles, is preferably applied by using conventional coaters such as a roll coater, spray coater, dip coater, spin coater or brush coater.

The present invention will be further described with reference to working examples thereof, and a comparative example.

### Example 1:

Use of 2-alkyl-alkylbenzimidazole as an active component in the preparation of preflux.

The 72 types of prefluxes were prepared from 2-alkyl-alkylbenzimidazoles (AABI-7 to AABI-72) listed in the following Table 1. A 1 g amount of each AABI and a 2 g amount of acetic acid were mixed, and the mixture was admixed with 100 g of water. The aqueous mixture was then heated to 50°C to prepare a 1% aqueous solution of AABI.

The test piece was prepared from a copper plate having a size of 1 cm x 5 cm x 0.3 mm. The copper plate was degreased, washed with water, soft-etched, washed with water, washed with acid, again washed with water, and the water-washed copper plate was then dried.

To evaluate a wettability by solder of the test piece, the water-washed and dried test piece was dipped in the previously prepared 1% AABI solution for 30 seconds, and the dip-coated test piece was washed with water and then heated at 200°C for 10 minutes in a hot air drier. After dipping the test piece in a bath of the postflux, a wettability by solder of the piece was determined by using a machine for testing the wettability by solder. The results are summarized in the following Table 1.

The wettability by solder was also determined for another test piece, which was further left to stand at 40°C and 90% RH (relative humidity) for 96 hours, after the dip coating of the postflux was completed. The results are summarized in the Table 1.

**Table 1**

| Wettability by solder (sec) at solder temperature of 240°C | | |
|---|---|---|
| benzimidazole | 200°C/10 min | 40°C/90% RH (after 96 hr) |
| AABI-7 | 0.87 | 0.66 |
| AABI-8 | 0.78 | 0.61 |
| AABI-9 | 0.80 | 0.66 |
| AABI-10 | 0.67 | 0.60 |
| AABI-11 | 0.78 | 0.63 |
| AABI-12 | 0.79 | 0.56 |
| AABI-13 | 0.59 | 0.47 |
| AABI-14 | 0.69 | 0.56 |
| AABI-15 | 0.74 | 0.53 |
| AABI-16 | 0.58 | 0.41 |
| AABI-17 | 0.89 | 0.53 |
| AABI-18 | 1.02 | 0.60 |
| AABI-19 | 0.68 | 0.54 |
| AABI-20 | 0.91 | 0.54 |
| AABI-21 | 0.70 | 0.51 |
| AABI-22 | 0.61 | 0.49 |
| AABI-23 | 0.68 | 0.59 |
| AABI-24 | 0.77 | 0.61 |
| AABI-25 | 0.51 | 0.38 |
| AABI-26 | 0.60 | 0.50 |
| AABI-27 | 0.65 | 0.51 |
| AABI-28 | 0.87 | 0.66 |
| AABI-29 | 0.86 | 0.59 |
| AABI-30 | 0.99 | 0.62 |
| AABI-31 | 1.24 | 0.44 |
| AABI-32 | 0.95 | 0.63 |
| AABI-33 | 0.88 | 0.67 |
| AABI-34 | 0.89 | 0.69 |
| AABI-35 | 0.91 | 0.69 |
| AABI-36 | 0.98 | 0.69 |
| AABI-37 | 0.97 | 0.76 |
| AABI-38 | 1.12 | 0.70 |
| AABI-39 | 1.03 | 0.69 |
| AABI-40 | 0.92 | 0.65 |
| AABI-41 | 0.93 | 0.65 |
| AABI-42 | 0.87 | 0.64 |
| AABI-43 | 0.90 | 0.67 |
| AABI-44 | 0.91 | 0.67 |
| AABI-45 | 0.89 | 0.61 |
| AABI-46 | 0.81 | 0.65 |
| AABI-47 | 0.72 | 0.58 |
| AABI-48 | 0.95 | 0.63 |
| AABI-49 | 0.60 | 0.44 |
| AABI-50 | 0.88 | 0.58 |
| AABI-51 | 0.77 | 0.64 |
| AABI-52 | 0.90 | 0.74 |
| AABI-53 | 0.92 | 0.69 |
| AABI-54 | 0.86 | 0.62 |
| AABI-55 | 0.90 | 0.65 |
| AABI-56 | 0.91 | 0.62 |
| AABI-57 | 0.97 | 0.65 |
| AABI-58 | 0.88 | 0.62 |
| AABI-59 | 0.95 | 0.59 |
| AABI-60 | 1.21 | 0.64 |
| AABI-61 | 0.94 | 0.61 |
| AABI-62 | 0.83 | 0.61 |
| AABI-63 | 0.90 | 0.59 |
| AABI-64 | 0.83 | 0.59 |
| AABI-65 | 0.78 | 0.60 |
| AABI-66 | 1.00 | 0.66 |
| AABI-67 | 0.89 | 0.62 |
| AABI-68 | 1.15 | 0.63 |
| AABI-69 | 0.84 | 0.63 |
| AABI-70 | 0.86 | 0.62 |
| AABI-71 | 0.86 | 0.62 |
| AABI-72 | 0.99 | 0.59 |

In addition, it was confirmed from the experiments that, for each of AABI-7 to AABI-72, a wetting time of the treated test piece is satisfactorily short.

### Comparative Example 1:

Use of 2-undecyl-4-methylimidazole as an active component in the preparation of preflux.

The procedure of the Example 1 was repeated, but for a comparison, the commercially available preflux "GLYCOAT T", product of Shikoku Kasei Kogyo Kabushiki Kaisha containing 2-undecyl-4-methylimidazole as an active component was used, and the copper plate as a test piece was dipped in an aqueous solution of "GLYCOAT T" at 30°C for 30 seconds. After dipping the test piece in a bath of the postflux, a wettability by solder of the piece was determined on a machine for testing the wettability by solder. The results indicated that the wettability is 10 seconds or more.

## Claims

1. A preflux composition for preventing oxidation and/or improving the solderability of copper or copper alloy circuits of printed circuit boards, comprising
(a) at least one non-volatile solvent selected from the group comprising organic acids, salts of organic acids, inorganic acids, salts of inorganic acids, methanol, ethanol, isopropyl alcohol, butanol, and acetone; and
(b) from 0.01 to 40% by weight of at least one benzimidazole compound represented by the following formula (I): 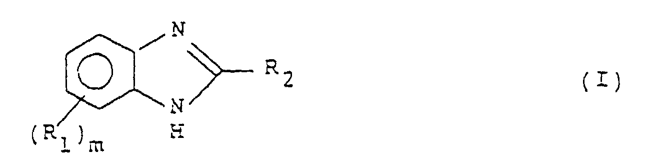
in which R₁ independently represents a substituted or unsubstituted alkyl group of 1 to 6 carbon atoms,
m is an integer from 0 to 2, and
R₂ independently represents a substituted or unsubstituted alkyl group of 3 to 17 carbon atoms and
the benzimidazole compound is selected from the group consisting of 2-n-propylbenzimidazole, 2-n-propyl-methylbenzimidazole, 2-n-propyl-dimethylbenzimidazole, 2-n-butyl-benzimidazole, 2-n-butyl-methylbenzimidazole, 2-n-butyl-dimethylbenzimidazole, 2-n-pentyl-benzimidazole, 2-n-pentyl-methylbenzimidazole, 2-n-pentyl-dimethylbenzimidazole, 2-n-hexyl-benzimidazole, 2-n-hexyl-methylbenzimidazole, 2-n-hexyl-dimethylbenzimidazole, 2-n-heptyl-benzimidazole, 2-n-heptyl-methylbenzimidazole, 2-n-heptyl-dimethylbenzimidazole, 2-n-octyl-benzimidazole, 2-n-octylmethylbenzimidazole, 2-n-octyl-dimethylbenzimidazole, 2-n-nonyl-benzimidazole, 2-n-nonyl-methylbenzimidazole, 2-n-nonyl-dimethylbenzimidazole, 2-n-decyl-benzimidazole, 2-n-decyl-methylbenzimidazole, 2-n-decyl-dimethylbenzimidazole, 2-n-undecyl-benzimidazole, 2-n-undecylmethylbenzimidazole, 2-n-undecyl-dimethylbenzimidazole, 2-n-dodecyl-benzimidazole, 2-n-dodecyl-methylbenzimidazole, 2-n-dodecyl-dimethylbenzimidazole, 2-n-tridecylbenzimidazole, 2-n-tridecyl-methylbenzimidazole, 2-n-tridecyl-dimethylbenzimidazole, 2-n-tetradecyl-benzimidazole, 2-n-tetradecyl-methylbenzimidazole, 2-n-tetradecyl-dimethylbenzimidazole, 2-n-pentadecyl-benzimidazole, 2-n-pentadecyl-methylbenzimidazole, 2-n-pentadecyl-dimethylbenzimidazole, 2-n-hexadecyl-benzimidazole, 2-n-hexadecyl-methylbenzimidazole, 2-n-hexadecyldimethylbenzimidazole, 2-n-heptadecyl-benzimidazole, 2-n-heptadecyl-methylbenzimidazole, 2-n-heptadecyldimethylbenzimidazole, 2-isopropyl-benzimidazole, 2-isopropyl-methylbenzimidazole, 2-isopropyl-dimethylbenzimidazole, 2-isobutyl-benzimidazole, 2-isobutylmethylbenzimidazole, 2-isobutyl-dimethylbenzimidazole, 2-isopentyl-benzimidazole, 2-isopentyl-methylbenzimidazole, 2-isopentyl-dimethylbenzimidazole, 2-isohexylbenzimidazole, 2-isohexyl-methylbenzimidazole, 2-isohexyl-dimethylbenzimidazole, 2-neopentyl-benzimidazole, 2-neopentyl-methylbenzimidazole, 2-neopentyldimethylbenzimidazole, 2-sec.-butyl-benzimidazole, 2-sec.-butyl-methylbenzimidazole, 2-sec.-butyldimethylbenzimidazole, 2-tert.-butyl-benzimidazole, 2-tert.-butyl-methylbenzimidazole, and 2-tert.-butyldimethylbenzimidazole.

2. A composition according to claim 1,
wherein the benzimidazole is a compound of formula I wherein R₂ is an unsubstituted alkyl group of 3 to 17 carbon atoms and m is zero.

3. A preflux composition for preventing oxidation and/or improving the solderability of cooper or copper alloy circuits of printed circuit boards, comprising
(a) at least one non-volatile solvent selected from the group consisting of acetic acid, capric acid, glycolic acid, para-nitrobenzoic acid, para-toluene sulfonic acid, piric acid, oxalic acid, formic acid, succinic acid, phosphorous acid, maleic acid, acrylic acid, fumaric acid, tartaric acid, adipic acid, lactic acid, oleic acid, salts of acetic acid, salts of capric acid, salts of glycolic acid, salts of para-nitrobenzoic acid, salts of para-toluene sulfonic acid, salts of picric acid, salts of oxalic acid, salts of formic acid, salts of succinic acid, salts of phosphorus acid, salts of maleic acid, salts of acrylic acid, salts of fumaric acid, salts of tartaric acid, salts of adipic acid, salts of lactic acid, salts of oleic acid, hydrochloric acid, sulfuric acid, phosphoric acid, zinc acetate, lead acetate, zinc hydroxide, lead hydroxide, zinc sulfide, zinc phosphate, zinc oxide, zinc chloride, ferrous chloride, ferric chloride, ferrous oxide, ferric oxide, cuprous chloride, cupric chloride, cuprous oxide, cupric oxide, copper hydroxide, copper (II) phosphate, copper (I) carbonate, copper (II) acetate, copper (II) sulfate, methanol, ethanol, isopropyl alcohol, butanol, and acetone; and
(b) from 0.01 to 40% by weigh of at least one benzimidazole compound selected from the group consisting of 2-n-propylbenzimidazole, 2-n-propyl-methylbenzimidazole, 2-n-propyl-dimethylbenzimidazole, 2-n-butyl-benzimidazole, 2-n-butyl-methylbenzimidazole, 2-n-butyl-dimethylbenzimidazole, 2-n-pentyl-benzimidazole, 2-n-pentyl-methylbenzimidazole, 2-n-pentyl-dimethylbenzimidazole, 2-n-hexyl-benzimidazole, 2-n-hexyl-methylbenzimidazole, 2-n-hexyl-dimethylbenzimidazole, 2-n-heptyl-benzimidazole, 2-n-heptyl-methylbenzimidazole, 2-n-heptyl-dimethylbenzimidazole, 2-n-octyl-benzimidazole, 2-n-octylmethylbenzimidazole, 2-n-octyl-dimethylbenzimidazole, 2-n-nonyl-benzimidazole, 2-n-nonyl-methylbenzimidazole, 2-n-nonyl-dimethylbenzimidazole, 2-n-decyl-benzimidazole, 2-n-decyl-methylbenzimidazole, 2-n-decyl-dimethylbenzimidazole, 2-n-undecyl-benzimidazole, 2-n-undecylmethylbenzimidazole, 2-n-undecyl-dimethylbenzimidazole, 2-n-dodecyl-benzimidazole, 2-n-dodecyl-methylbenzimidazole, 2-n-dodecyl-dimethylbenzimidazole, 2-n-tridecylbenzimidazole, 2-n-tridecyl-methylbenzimidazole, 2-n-tridecyl-dimethylbenzimidazole, 2-n-tetradecyl-benzimidazole, 2-n-tetradecyl-methylbenzimidazole, 2-n-tetradecyl-dimethylbenzimidazole, 2-n-pentadecyl-benzimidazole, 2-n-pentadecyl-methylbenzimidazole, 2-n-pentadecyl-dimethylbenzimidazole, 2-n-hexadecyl-benzimidazole, 2-n-hexadecyl-methylbenzimidazole, 2-n-hexadecyldimethylbenzimidazole, 2-n-heptadecyl-benzimidazole, 2-n-heptadecyl-methylbenzimidazole, 2-n-heptadecyldimethylbenzimidazole, 2-isoproyl-benzimidazole, 2-isopropyl-methylbenzimidazole, 2-isopropyl-dimethylbenzimidazole, 2-isobutyl-benzimidazale, 2-isobutylmethylbenzimidazole, 2-isobutyl-dimethylbenzimidazole, 2-isopentyl-benzimidazole, 2-isopentyl-methylbenzimidazole, 2-isopentyl-dimethylbenzimidazole, 2-isohexylbenzimidazole, 2-isohexyl-methylbenzimidazole, 2-isohexyl-dimethylbenzimidazole, 2-neopentyl-benzimidazole, 2-neopentyl-methylbenzimidazole, 2-neopentyldimethylbenzimidazole, 2-sec.-butyl-benzimidazole, 2-sec.-butyl-methylbenzimidazole, 2-sec.-butyldimethylbenzimidazole, 2-tert.-butyl-benzimidazole, 2-tert.-butyl-methylbenzimidazole, and 2-tert.-butyldimethylbenzimidazole.

## Patentansprüche

1. Flußmittelzusammensetzung zum Verhindern der Oxidation und/oder zur Verbesserung der Lötbarkeit von Schaltungen aus Kupfer oder Kupferlegierungen gedruckter Schaltungen, umfassend
(a) mindestens ein nichtflüchtiges Lösungsmittel, das aus der aus organischen Säuren, Salzen organischer Säuren, anorganischen Säuren, Salzen anorganischer Säuren, Methanol, Ethanol, Isopropylalkohol, Butanol und Aceton bestehenden Gruppe ausgewählt ist, und
(b) 0,01 bis 40 Gew.% mindestens einer Benzimidazolverbindung der folgenden Formel (I) 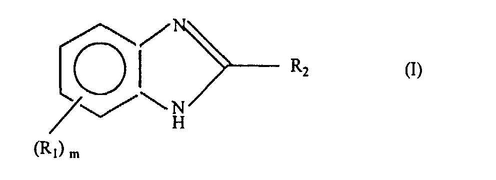
worin R₁ unabhängig eine gegebenenfalls substituierte Alkylgruppe mit 1 bis 6 Kohlenstoffatomen bedeutet, m ganzzahlig von 0 bis 2 ist und
R₂ unabhängig eine gegebenenfalls substituierte Alkylgruppe mit 3 bis 17 Kohlenstoffatomen bedeutet und die Benzimidazolverbindung aus der Gruppe ausgewählt ist, welche aus 2-n-Propyl-benzimidazol, 2-n-Propyl-methylbenzimidazol, 2-n-Propyl-dimethylbenzimidazol, 2-n-Butylbenzimidazol, 2-n-Butyl-methylbenzimidazol, 2-n-Butyldimethylbenzimidazol, 2-n-Pentylbenzimidazol, 2-n-Pentylmethylbenzimidazol, 2-n-Pentyl-dimethylbenzimidazol, 2-n-Hexylbenzimidazol, 2-n-Hexyl-methylbenzimidazol, 2-n-Hexyl-dimethylbenzimidazol, 2-n-Heptylbenzimidazol, 2-n-Heptyl-methylbenzimidazol, 2-n-Heptyl-dimethylbenzimidazol, 2-n-Octyl-benzimidazol, 2-n-Octyl-methylbenzimidazol, 2-n-Octyl-dimethylbenzimidazol, 2-n-Nonylbenzimidazol, 2-n-Nonylmethylbenzimidazol, 2-n-Nonyldimethylbenzimidazol, 2-n-Decyl-benzimidazol, 2-n-Decylmethylbenzimidazol, 2-n-Decyl-dimethylbenzimidazol, 2-n-Undecyl-benzimidazol, 2-n-Undecyl-methylbenzimidazol, 2-n-Undecyl-dimethylbenzimidazol, 2-n-dodecylbenzimidazol, 2-n-Dodecyl-methylbenzimidazol, 2-n-Dodecyl-dimethylbenzimidazol, 2-n-tridecylbenzimidazol, 2-n-Tridecyl-methylbenzimidazol, 2-n-Tridecyl-dimethylbenzimidazol, 2-n-Tetradecylbenzimidazol, 2-n-Tetradecyl-methylbenzimidazol, 2-n-Tetradecyl-dimethylbenzimidazol, 2-n-Pentadecylbenzimidazol, 2-n-Pentadecyl-methylbenzimidazol, 2-n-Pentadecyl-dimethylbenzimidazol, 2-n-Hexadecylbenzimidazol, 2-n-Hexadecyl-methylbenzimidazol, 2-n-Hexadecyl-dimethylbenzimidazol, 2-n-Heptadecylbenzimidazol, 2-n-Heptadecyl-methylbenzimidazol, 2-n-Heptadecyl-dimethylbenzimidazol, 2-Isopropylbenzimidazol, 2-Isopropyl-methylbenzimidazol, 2-Isopropyl-dimethylbenzimidazol, 2-Isobutylbenzimidazol, 2-Isobutyl-methylbenzimidazol, 2-Isobutyl-dimethylbenzimidazol, 2-Isopentylbenzimidazol, 2-Isopentylmethylbenzimidazol, 2-Isopentyl-dimethylbenzimidazol, 2-Isohexyl-benzimidazol, 2-Isohexyl-methylbenzimidazol, 2-Isohexyl-dimethylbenzimidazol, 2-Neopentylbenzimidazol, 2-Neopentyl-methylbenzimidazol, 2-Neopentyldimethylbenzimidazol, 2-*sec*.-Butyl-benzimidazol, 2-*sec.*-Butyl-methylbenzimidazol, 2-*sec*.-Butyl-dimethylbenzimidazol, 2-*tert*.-Butyl-benzimidazol, 2-*tert*.-Butylmethylbenzimidazol und 2-*tert*.-Butyl-dimethylbenzimidazol besteht.

2. Zusammensetzung nach Anspruch 1, wobei das Benzimidazol eine Verbindung der Formel I ist, worin R₂ eine nicht substituierte Alkylgruppe mit 3 bis 17 Kohlenstoffatomen bedeutet und m gleich Null ist.

3. Flußmittelzusammensetzung zum Verhindern der Oxidation und/oder zur Verbesserung der Lötbarkeit von Schaltungen aus Kupfer oder Kupferlegierungen gedruckter Schaltungen, umfassend
(a) mindestens ein nichtflüchtiges Lösungsmittel, das aus der Gruppe ausgewählt ist, welche aus Essigsäure, Caprinsäure, Glycolsäure, p-Nitrobenzoesäure, p-Toluolsulfonsäure, Pikrinsäure, Oxalsäure, Ameisensäure, Bernsteinsäure, phosphoriger Säure, Maleinsäure, Acrylsäure, Fumarsäure, Weinsäure, Adipinsäure, Milchsäure, Oleinsäure, Salzen der Essigsäure, Salzen der Caprinsäure, Salzen der Glycolsäure, Salzen der p-Nitrobenzoesäure, Salzen der p-Toluolsulfonsäure, Salzen der Pikrinsäure, Salzen der Oxalsäure, Salzen der Ameisensäure, Salzen der Bernsteinsäure, Salzen der phosphorigen Säure, Salzen der Maleinsäure, Salzen der Acrylsäure, Salzen der Fumarsäure, Salzen der Weinsäure, Salzen der Adipinsäure, Salzen der Milchsäure, Salzen der Oleinsäure, Salzsäure, Schwefelsäure, Phosphorsäure, Zinkacetat, Bleiacetat, Zinkhydroxid, Bleihydroxid, Zinksulfid, Zinkphosphat, Zinkoxid, Zinkchlorid, Eisen(II)-chlorid, Eisen(III)-chlorid, Eisen(II)-oxid, Eisen(III)-oxid, Kupfer(I)-chlorid, Kupfer(II)-chlorid, Kupfer(I) -oxid, Kupfer(II)-oxid, Kupferhydroxid, Kupfer(II)-phosphat, Kupfer(I)-carbonat, Kupfer(II)-acetat, Kupfer(II)-sulfat, Methanol, Ethanol, Isopropylalkohol, Butanol und Aceton besteht, und
(b) 0,01 bis 40 Gew.-% mindestens einer Benzimidazolverbindung, welche aus der Gruppe ausgewählt ist, die aus 2-n-Propylbenzimidazol, 2-n-Propylmethylbenzimidazol, 2-n-Propyl-dimethylbenzimidazol, 2-n-Butylbenzimidazol, 2-n-Butylmethylbenzimidazol, 2-n-Butyldimethylbenzimidazol, 2-n-Pentylbenzimidazol, 2-n-Pentyl-methylbenzimidazol, 2-n-Pentyl-dimethylbenzimidazol, 2-n-Hexylbenzimidazol, 2-n-Hexyl-methylbenzimidazol, 2-n-Hexyl-dimethylbenzimidazol, 2-n-Heptylbenzimidazol, 2-n-Heptyl-methylbenzimidazol, 2-n-Heptyldimethylbenzimidazol, 2-n-Octyl-benzimidazol, 2-n-Octylmethylbenzimidazol, 2-n-Octyl-dimethylbenzimidazol, 2-n-Nonylbenzimidazol, 2-n-Nonylmethylbenzimidazol, 2-n-Nonyl-dimethylbenzimidazol, 2-n-Decyl-benzimidazol, 2-n-Decyl-methylbenzimidazol, 2-n-Decyl-dimethylbenzimidazol, 2-n-Undecyl-benzimidazol, 2-n-Undecylmethylbenzimidazol, 2-n-Undecyl-dimethylbenzimidazol, 2-n-Dodecylbenzimidazol, 2-n-Dodecyl-methylbenzimidazol, 2-n-Dodecyl-dimethylbenzimidazol, 2-n-Tridecylbenzimidazol, 2-n-Tridecyl-methylbenzimidazol, 2-n-Tridecyl-dimethylbenzimidazol, 2-n-Tetradecylbenzimidazol, 2-n-Tetradecyl-methylbenzimidazol, 2-n-Tetradecyl-dimethylbenzimidazol, 2-n-Pentadecyl-benzimidazol, 2-n-Pentadecyl-methylbenzimidazol, 2-n-Pentadecyl-dimethylbenzimidazol, 2-n-Hexadecyl-benzimidazol, 2-n-Hexadecyl-methylbenzimidazol, 2-n-Hexadecyl-dimethylbenzimidazol, 2-n-Heptadecyl-benzimidazol, 2-n-Heptadecylmethylbenzimidazol, 2-n-Heptadecyl-dimethylbenzimidazol, 2-Isopropylbenzimidazol, 2-Isopropyl-methylbenzimidazol, 2-Isopropyl-dimethylbenzimidazol, 2-Isobutylbenzimidazol, 2-Isobutyl-methylbenzimidazol, 2-Isobutyl-dimethylbenzimidazol, 2-Isopentylbenzimidazol, 2-Isopentylmethylbenzimidazol, 2-Isopentyl-dimethylbenzimidazol, 2-Isohexyl-benzimidazol, 2-Isohexyl-methylbenzimidazol, 2-Isohexyl-dimethylbenzimidazol, 2-Neopentylbenzimidazol, 2-Neopentyl-methylbenzimidazol, 2-Neopentyl-dimethylbenzimidazol, 2-*sec.*-Butyl-benzimidazol, 2-*sec*.-Butylmethylbenzimidazol, 2-*sec*.-Butyl-dimethylbenzimidazol, 2-*tert*.-Butyl-benzimidazol, 2-*tert*.-Butylmethylbenzimidazol und 2 -*tert*. -Butyl -dimethylbenzimidazol besteht.

## Revendications

1. Composition de préflux pour empêcher l'oxydation et/ou améliorer la soudabilité de circuits en cuivre ou alliages de cuivre de cartes à circuits imprimés, comprenant
(a) au moins un solvant non volatil choisi dans le groupe comprenant des acides organiques, des sels d'acides organiques, des acides inorganiques, des sels d'acides inorganiques, le méthanol, l'éthanol, l'alcool isopropylique, le butanol et l'acétone ; et
(b) 0,01 à 40 % en poids d'au moins un benzimidazole représenté par la formule (I) suivante : 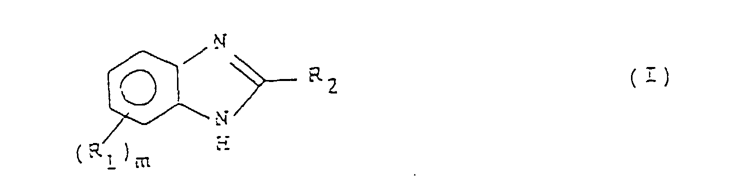
dans laquelle R₁ représente, indépendamment, un groupe alkyle de 1 à 6 atomes de carbone, substitué ou non substitué,
m représente un nombre entier de 0 à 2, et
R₂ représente, indépendamment, un groupe alkyle de 3 à 17 atomes de carbone, substitué ou non substitué, et
le benzimidazole est choisi dans le groupe consistant en 2-n-propyl-benzimidazole, 2-n-propyl-méthylbenzimidazole, 2-n-propyl-diméthylbenzimidazole, 2-n-butylbenzimidazole, 2-n-butyl-méthylbenzimidazole, 2-n-butyldiméthylbenzimidazole, 2-n-pentyl-benzimidazole, 2-n-pentylméthylbenzimidazole, 2-n-pentyl-diméthylbenzimidazole, 2-n-hexyl-benzimidazole, 2-n-hexyl-méthylbenzimidazole, 2-n-hexyl-diméthylbenzimidazole, 2-n-heptyl-benzimidazole, 2-n-heptyl-méthylbenzimidazole, 2-n-heptyl-diméthylbenzimidazole, 2-n-octyl-benzimidazole, 2-n-octyl-méthylbenzimidazole, 2-n-octyl-diméthylbenzimidazole, 2-n-nonyl-benzimidazole, 2-n-nonyl-méthylbenzimidazole, 2-n-nonyl-diméthylbenzimidazole, 2-n-décyl-benzimidazole, 2-n-décyl-méthylbenzimidazole, 2-n-décyl-diméthylbenzimidazole, 2-n-undécyl-benzimidazole, 2-n-undécyl-méthylbenzimidazole, 2-n-undécyl-diméthylbenzimidazole, 2-n-dodécyl-benzimidazole, 2-n-dodécylméthylbenzimidazole, 2-n-dodécyl-diméthylbenzimidazole, 2-n-tridécyl-benzimidazole, 2-n-tridécyl-méthylbenzimidazole, 2-n-tridécyl-diméthylbenzimidazole, 2-n-tétradécyl-benzimidazole, 2-n-tétradécyl-méthylbenzimidazole, 2-n-tétradécyl-diméthylbenzimidazole, 2-n-pentadécyl-benzimidazole, 2-n-pentadécyl-méthylbenzimidazole, 2-n-pentadécyl-diméthyl-benzimidazole, 2-n-hexadécyl-benzimidazole, 2-n-hexadécylméthylbenzimidazole, 2-n-hexadécyl-diméthylbenzimidazole, 2-n-heptadécyl-benzimidazole, 2-n-heptadécyl-méthylbenzimidazole, 2-n-heptadécyl-diméthylbenzimidazole, 2-isopropyl-benzimidazole, 2-isopropyl-méthylbenzimidazole, 2-isopropyl-diméthylbenzimidazole, 2-isobutyl-benzimidazole, 2-isobutyl-méthylbenzimidazole, 2-isobutyl-diméthylbenzimidazole, 2-isopentyl-benzimidazole, 2-isopentylméthylbenzimidazole, 2-isopentyl-diméthylbenzimidazole, 2-isohexyl-benzimilidazole, 2-isohexyl-méthylbenzimidazole, 2-isohexyl-diméthylbenzimidazole, 2-néopentyl-benzimidazole, 2-néopentyl-méthylbenzimidazole, 2-néopentyl-diméthylbenzimidazole, 2-sec.-butyl-benzimidazole, 2-sec.-butyl-méthylbenzimidazole, 2-sec.-butyl-diméthylbenzimidazole, 2-tertiobutyl-benzimidazole, 2-tertio-butyl-méthylbenzimidazole et 2-tertio-butyl-diméthylbenzimidazole.

2. Composition suivant la revendication 1, dans laquelle le benzimidazole est un composé de formule I dans laquelle R₂ représente un groupe alkyle de 3 à 17 atomes de carbone, non substitué, et m est égal à zéro.

3. Composition de préflux pour empêcher l'oxydation et/ou améliorer la soudabilité de circuits en cuivre ou alliages de cuivre de cartes à circuits imprimés, comprenant :
(a) au moins un solvant non volatil choisi dans le groupe consistant en l'acide acétique, l'acide caprique, l'acide glycolique, l'acide para-nitrobenzoique, l'acide para-toluènesulfonique, l'acide pirique, l'acide oxalique, l'acide formique, l'acide succinique, l'acide phosphoreux, l'acide maléique, l'acide acrylique, l'acide fumarique, l'acide tartrique, l'acide adipique, l'acide lactique, l'acide oléique, des sels d'acide acétique, des sels d'acide caprique, des sels d'acide glycolique, des sels d'acide para-nitrobenzoïque, des sels d'acide para-toluènesulfonique, des sels d'acide picrique, des sels d'acide oxalique, des sels d'acide formique, des sels d'acide succinique, des sels d'acide phosphoreux, des sels d'acide maléique, des sels d'acide acrylique, des sels d'acide fumarique, des sels d'acide tartrique, des sels d'acide adipique, des sels d'acide lactique, des sels d'acide oléique, l'acide chlorhydrique, l'acide sulfurique, l'acide phosphorique, l'acétate de zinc, l'acétate de plomb, l'hydroxyde de zinc, l'hydroxyde de plomb, le sulfure de zinc, le phosphate de zinc, l'oxyde de zinc, le chlorure de zinc, le chlorure ferreux, le chlorure ferrique, l'oxyde ferreux, l'oxyde ferrique, le chlorure cuivreux, le chlorure cuivrique, l'oxyde cuivreux, l'oxyde cuivrique, l'hydroxyde de cuivre, le phosphate de cuivre (II), le carbonate de cuivre (I), l'acétate de cuivre (II), le sulfate de cuivre (II), le méthanol, l'éthanol, l'alcool isopropylique, le butanol et l'acétone ; et
(b) 0,01 à 40 % en poids d'au moins un benzimidazole choisi dans le groupe consistant en 2-n-propylbenzimidazole, 2-n-propyl-méthylbenzimidazole, 2-n-propyldiméthylbenzimidazole, 2-n-butyl-benzimidazole, 2-n-butylméthylbenzimidazole, 2-n-butyl-diméthylbenzimidazole, 2-n-pentyl-benzimidazole, 2-n-pentyl-méthylbenzimidazole, 2-n-pentyl-diméthylbenzimidazole, 2-n-hexyl-benzimidazole, 2-n-hexyl-méthylbenzimidazole, 2-n-hexyl-diméthylbenzimidazole, 2-n-heptyl-benzimidazole, 2-n-heptyl-méthylbenzimidazole, 2-n-heptyl-diméthylbenzimidazole, 2-n-octyl-benzimidazole, 2-n-octyl-méthylbenzimidazole, 2-n-octyl-diméthylbenzimidazole, 2-n-nonyl-benzimidazole, 2-n-nonyl-méthylbenzimidazole, 2-n-nonyl-diméthylbenzimidazole, 2-n-décyl-benzimidazole, 2-n-décyl-méthylbenzimidazole, 2-n-décyl-diméthylbenzimidazole, 2-n-undécyl-benzimidazole, 2-n-undécyl-méthylbenzimidazole, 2-n-undécyl-diméthylbenzimidazole, 2-n-dodécyl-benzimidazole, 2-n-dodécyl-méthylbenzimidazole, 2-n-dodécyl-diméthylbenzimidazole, 2-n-tridécyl-benzimidazole, 2-n-tridécylméthylbenzimidazole, 2-n-tridécyl-diméthylbenzimidazole, 2-n-tétradécyl-benzimidazole, 2-n-tétradécyl-méthylbenzimidazole, 2-n-tétradécyl-diméthylbenzimidazole, 2-n-pentadécyl-benzimidazole, 2-n-pentadécyl-méthylbenzimidazole, 2-n-pentadécyl-diméthylbenzimidazole, 2-n-hexadécyl-benzimidazole, 2-n-hexadécyl-méthylbenzimidazole, 2-n-hexadécyl-diméthylbenzimidazole, 2-n-heptadécyl-benzimidazole, 2-n-heptadécylméthylbenzimidazole, 2-n-heptadécyl-diméthylbenzimidazole, 2-isopropyl-benzimidazole, 2-isopropyl-méthylbenzimidazole, 2-isopropyl-diméthylbenzimidazole, 2-isobutyl-benzimidazole, 2-isobutyl-méthylbenzimidazole, 2-isobutyl-diméthylbenzimidazole, 2-isopentyl-benzimidazole, 2-isopentylméthylbenzimidazole, 2-isopentyl-diméthylbenzimidazole, 2-isohexyl-benzimilidazole, 2-isohexyl-méthylbenzimidazole, 2-isohexyl-diméthylbenzimidazole, 2-néopentyl-benzimidazole, 2-néopentyl-méthylbenzimidazole, 2-néopentyl-diméthylbenzimidazole, 2-sec.-butyl-benzimidazole, 2-sec.-butyl-méthylbenzimidazole, 2-sec.-butyl-diméthylbenzimidazole, 2-tertiobutyl-benzimidazole, 2-tertio-butyl-méthylbenzimidazole et 2-tertio-butyl-diméthylbenzimidazole.
